# EUROPEAN PATENT APPLICATION

(11) **EP 4 734 695 A1**
(43) Date of publication of application: **29.04.2026**
(21) Application number: 25209497.4
(22) Date of filing: 17.10.2025
(51) Int. Cl.: H10D 8/60, H10D 8/01, H10D 62/60

(54) **METHOD FOR MANUFACTURING A TRENCH SCHOTTKY DIODE WITH ADJUSTABLE FORWARD VOLTAGE**

(30) Priority: 28.10.2024 US 202463712769 P; 03.10.2025 US 202519349359
(71) Applicant: STMicroelectronics International N.V., 1228 Plan-les-Ouates, Geneva (CH)
(72) Inventor: NGWAN, Voon Cheng, 732686 SINGAPORE (SG); LANOIS, Frederic, 37100 TOURS (FR)
(74) Representative: Cabinet Beaumont

(57) **Abstract**

A Schottky diode includes a substrate with an active region. Sidewall and bottom surfaces of trench (140) extending into an epitaxial layer (104) of the substrate are lined with an insulating layer (150), and the remainder of each trench is filled with a polycrystalline silicon (polysilicon) fill (160). A doped region (164) having the same conductivity type dopant as the semiconductor substrate is implanted in the epitaxial layer at locations between adjacent trenches. A silicide (172) is provided at each polysilicon fill and a Schottky barrier (170) is provided at each doped region. An anode contact (189) for the diode contacts the silicide and Schottky barrier, and a cathode contact (196) for the diode contacts a lower surface of the substrate. The selection of a dopant concentration level for the doped region controls setting of a forward voltage V_{F} level for the Schottky diode.

## Description

### CROSS-REFERENCE TO RELATED APPLICATIONS

This application claims priority to United States Provisional Application for Patent No. 63/712,769, filed October 28, 2024, and to United States Non-Provisional Application for Patent No. 19/349,359, filed October 3, 2025, the contents of which are incorporated herein by reference.

### TECHNICAL FIELD

The present invention generally relates to an integrated circuit and, more particularly, to a method for manufacturing a Schottky diode having a tunable forward voltage V_{F}.

### BACKGROUND

Trench-type Schottky diodes are known in the art as an improvement over planar-type Schottky diodes. A limitation of the planar-type Schottky diode is that the equipotential field lines tend to be crowded close to the metal electrode and not the substrate. This can lead to an increase in leakage current with increasing reverse voltage and an early breakdown. The trench-type Schottky diode uses trenches etched into the substrate and filled with a conductive material (such as a polycrystalline silicon (i.e., polysilicon) material) insulated from the substrate by an insulating layer in the trench. The conductive material filling the trenches acts as a field plate in the substrate that effectively depletes the drift region in the reverse direction and flattens the profile of the electric field along the drift region. As a result, there is an increase in the effective electric field, and an improved tradeoff between the forward voltage V_{F} of the diode and the reverse leakage current I_{R} of the diode.

Trench-type Schottky diodes thus exhibit a wider safe operating area in comparison to equivalent planar-type Schottky diodes, and are robust against thermal runaway.

Depending on application, the tradeoff between V_{F} and I_{R} can be modified by changing the area of the integrated circuit and/or changing the type of metal with a different work function for the Schottky barrier. The issue with this is that both ways of modification require cumbersome process changes and design modifications to produce Schottky diodes having different forward voltage V_{F} levels.

There is a need in the art for an improved manufacturing method for trench-type Schottky diodes which permits tuning of the forward voltage V_{F} of the diode. Preferably, tuning the forward voltage V_{F} of the diode can be accomplished during manufacture without necessitating a design change or a change in the Schottky barrier metal.

### SUMMARY

In an embodiment, a method for manufacturing a Schottky diode comprises: in an active region of a semiconductor substrate doped with a first conductivity type dopant, forming a plurality of trenches which extend in depth into an epitaxial layer of the semiconductor substrate from an upper surface of the semiconductor substrate; lining sidewall and bottom surfaces of each trench with an insulating layer; filling each trench with a polycrystalline silicon (polysilicon) fill; implanting a doped region having the first conductivity type dopant in the epitaxial layer of the semiconductor substrate at locations between adjacent trenches; providing a silicide in contact with each polysilicon fill; providing a Schottky barrier in contact with each doped region; providing a first electrical connection for an anode terminal in contact with the silicide and Schottky barrier; and providing a second electrical connection for a cathode terminal in contact with a lower surface of the semiconductor substrate.

The step for implanting the doped region includes a step for selecting a dopant surface concentration level for the implanted first conductivity type dopant at the doped region to control setting of a forward voltage V_{F} level for the Schottky diode. This can be accomplished, for example, by controlling the dose of the implantation and the energy level used for the implantation.

When selecting the dopant surface concentration level, the selection of a relatively higher dopant surface concentration level, corresponding to selection of a relatively higher implantation dose level, for the implanted the first conductivity type dopant results in the controlled setting of a relatively lower forward voltage V_{F} level of the produced Schottky diode.

Thus, Schottky diodes having different forward voltage V_{F} levels can be manufactured by inclusion of a doped surface region between adjacent substrate trenches in an epitaxial layer of the substrate and the selection of a dopant surface concentration level for the implanted doped surface region corresponding to the desired forward voltage V_{F} level.

In an embodiment, a Schottky diode comprises: a semiconductor substrate doped with a first conductivity type dopant in an active region of the semiconductor substrate, a plurality of trenches extending in depth into an epitaxial layer of the semiconductor substrate from an upper surface of the semiconductor substrate; an insulating layer lining sidewall and bottom surfaces of each trench; a polycrystalline silicon (polysilicon) fill in each trench; a doped region having the first conductivity type dopant implanted in the epitaxial layer of the semiconductor substrate at locations between adjacent trenches; a silicide in contact with each polysilicon fill; a Schottky barrier in contact with each doped region; a first electrical connection for an anode terminal in contact with the silicide and Schottky barrier; and a second electrical connection for a cathode terminal in contact with a lower surface of the semiconductor substrate; wherein a dopant surface concentration level of the first conductivity type dopant implanted at the doped region controls setting of a forward voltage V_{F} level for the Schottky diode.

In an embodiment, a method for manufacturing a Schottky diode comprises: selecting a forward voltage V_{F} level for the Schottky diode; selecting, based on the selected forward voltage V_{F} level, a dose level for implanting a first conductivity type dopant having a certain dopant concentration level; in an active region of a semiconductor substrate doped with a first conductivity type dopant, forming a pair of trenches which extend in depth into a semiconductor substrate; lining sidewall and bottom surfaces of the pair of trenches with an insulating layer; filling each trench with a polysilicon fill; implanting, using the selected a dose level, a doped region having the first conductivity type dopant in the semiconductor substrate between the pair of trenches to set the selected forward voltage V_{F} level for the Schottky diode; forming a silicide in contact with the polysilicon fill; forming a Schottky barrier in contact with the doped region; connecting an anode terminal to the silicide and Schottky barrier; and connecting a cathode terminal to a lower surface of the semiconductor substrate.

A relatively higher dopant concentration level for the certain dopant concentration level corresponds to selecting a relatively lower forward voltage V_{F} level. Thus, selecting a relatively higher dose level corresponds to selecting a relatively lower forward voltage V_{F} level.

### BRIEF DESCRIPTION OF THE DRAWINGS

For a better understanding of the embodiments, reference will now be made by way of example only to the accompanying figures in which:
Figure 1 is a cross-sectional view of a trench-type Schottky diode;
Figures 2A-2R show steps in a process for manufacturing the trench-type Schottky diode of Figure 1; and
Figure 3 is a graph showing the tuning effect for forward voltage V_{F} of the Schottky diode dependent on dopant dose level for implanting a doped region within the substrate.

### DETAILED DESCRIPTION

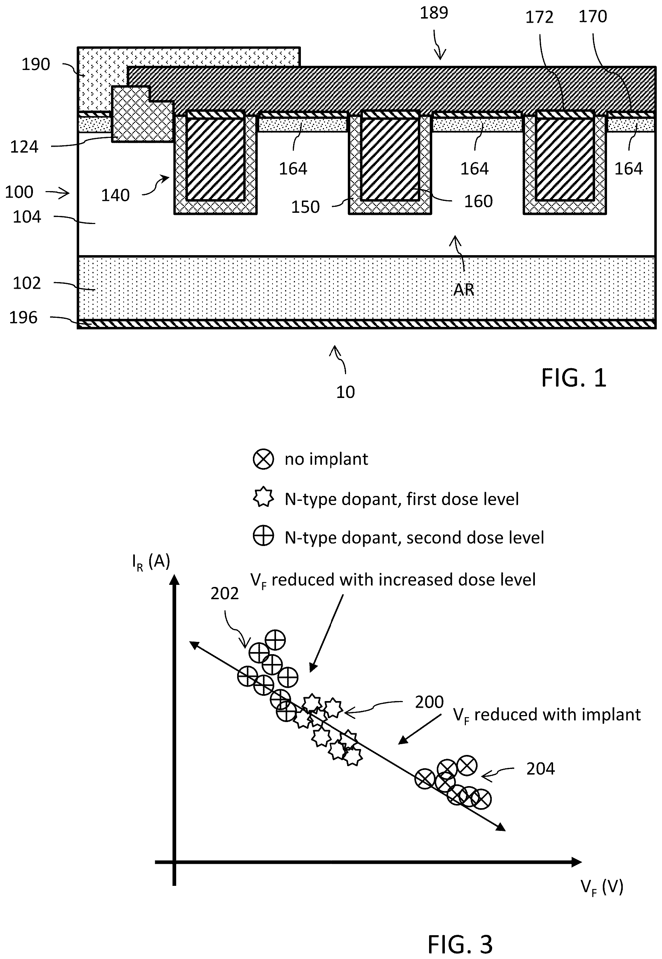

Reference is now made to Figure 1 which shows a cross-sectional view of a trench-type Schottky diode 10. The diode 10 is formed in and on a substrate 100 which includes a substrate layer 102 and an epitaxial layer 104. The epitaxial layer 104 forms a drift region of the diode 10. The substrate layer 102 is heavily doped with an N-type conductivity dopant and the epitaxial layer 104 is lightly doped with an N-type conductivity dopant. Reference to "heavily" and "lightly" in this context refers, for example, to the relative dopant concentration levels in doped regions where a heavily doped region has a higher dopant concentration level than a lightly doped region. An active region AR of the substrate 100 is delimited by a field oxide region 124. Within the active region, a plurality of trenches 140 are formed. These trenches 140 extend in depth from the upper surface of the substrate at least partially through the epitaxial layer 104. The sidewall and bottom surfaces of each trench 140 are lined with an insulating layer 150, and the remainder of the trench is filled with a polycrystalline silicon (i.e., polysilicon) trench fill 160. A doped region 164 is implanted in the epitaxial layer 104 between adjacent trenches 140. The doped region 164 is doped with an N-type conductivity dopant and has a dopant surface concentration level selected to control setting of a forward voltage V_{F} level for the Schottky diode. A Schottky barrier 170 is provided on the upper surface each doped region 164 and a silicide layer 172 is provided on the upper surface of each polysilicon trench fill 160. A stack 189 of metal layers is provided over the active region at the upper surface of the substrate 100 in contact with the Schottky barriers 170 and silicide layers 172 to provide a first diode electrical contact (for example, for the anode terminal). A metal layer 196 is provided at the back surface of the substrate to provide a second diode electrical contact (for example, for the cathode terminal). A passivation at the front side is provided by an organic polymeric layer 192 which includes an opening exposing a portion of the upper surface of the stack 189 of metal layers (in support of either clip or wirebonding connection).

A dose level of the dopant implantation for forming region 164 is selected during manufacture to control the selected dopant surface concentration level and tune the forward voltage V_{F} of the diode. The implantation of region 164 (lightly doped N-type) at the surface of the substrate 100, between adjacent trenches 140 at the location of the Schottky barrier 172, causes band bending near the upper surface and reduces the effective Schottky barrier height resulting in a lowering of the forward voltage V_{F}. The degree of lowering can be controlled by selectively choosing the level of the dopant implantation dose, with selection a relatively higher dose level (and associated relatively higher dopant surface concentration level in region 164) correlating to production of a Schottky diode 10 having a relatively lower forward voltage V_{F} level.

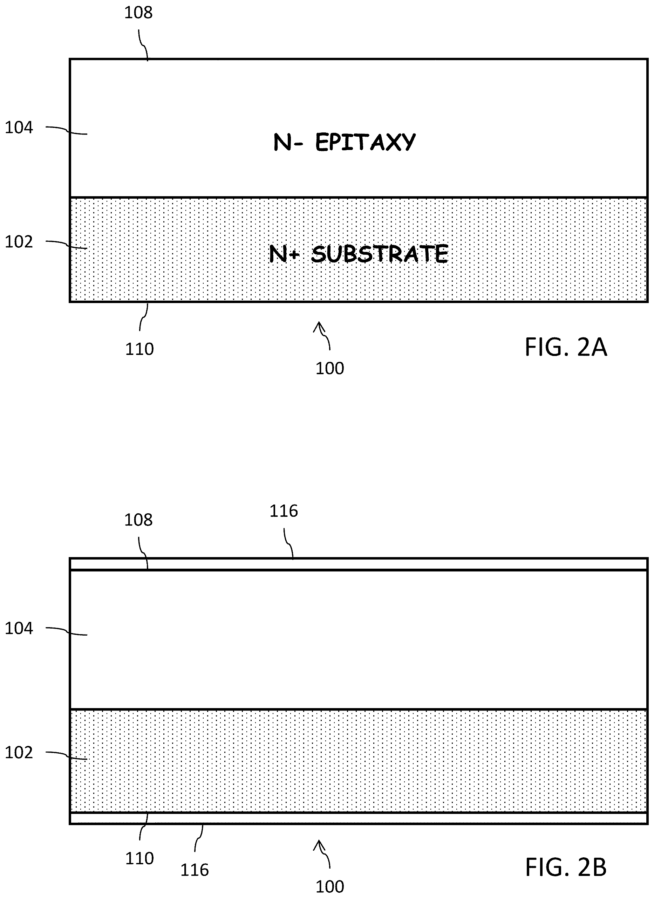

Reference is now made to Figures 2A-2R which show steps in a process for manufacturing the trench-type Schottky diode 10 of Figure 1.

Figure 2A - a semiconductor substrate wafer 100 is provided. The substrate wafer 100 includes a substrate layer 102 of single crystal semiconductor material such as Silicon that is heavily doped with an N-type dopant such as Arsenic (with a dopant concentration level of, for example, about 1 x 10²⁰ at/cm³), and an epitaxial layer 104 having a thickness in a range of, for example, 2 to 20 µm that is lightly doped with an N-type dopant (providing a resistivity in a range of, for example, 0.5 to 5 Ω.cm with a dopant concentration level of in a range of, for example, 1 x 10¹⁵ to 1 x 10¹⁶ at/cm³). It will be noted that both the thickness and resistivity of the epitaxial layer 104 are selected according to a targeted breakdown voltage for the Schottky diode. The substrate wafer 100 has an upper surface 108 and a lower surface 110.

Figure 2B - the surfaces 108 and 110 of the wafer 100 are then cleaned using a conventional wafer clearing process and a low pressure chemical vapor deposition (LPCVD) process is used to deposit a thin nitride layer 116 on each of the surfaces 108 and 110. The nitride layer 116 has a thickness in a range of, for example, 100 to 1000 Å.

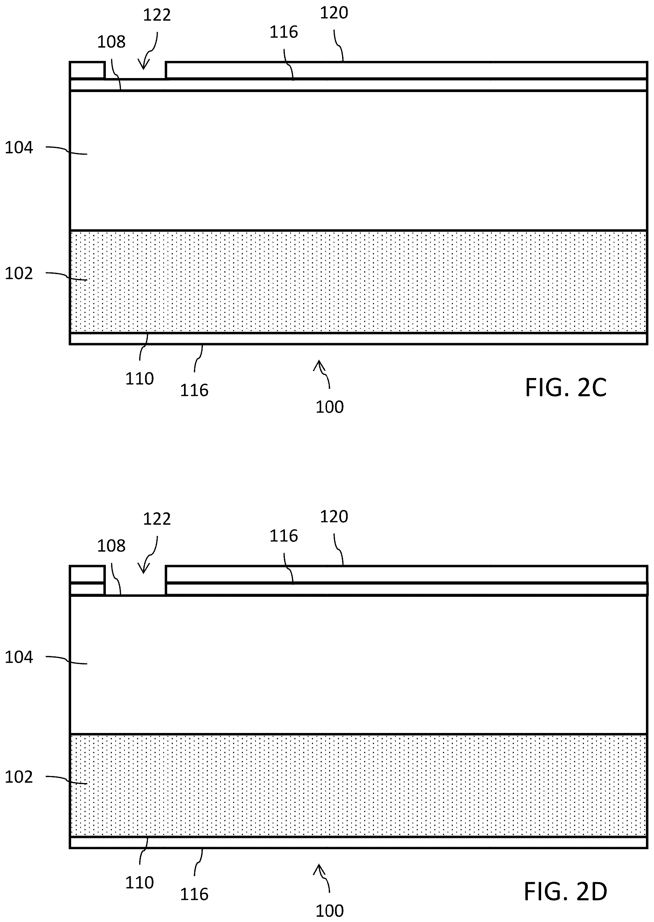

Figure 2C - a resist layer 120 is deposited on the thin nitride layer 116 over the upper surface 108 and lithographically patterned to form a mask opening 122 (for field oxide formation).

Figure 2D - a nitride dry etching is then performed through the opening 122 to remove a portion of the nitride layer 116 at each opening 122 and expose the upper surface 108.

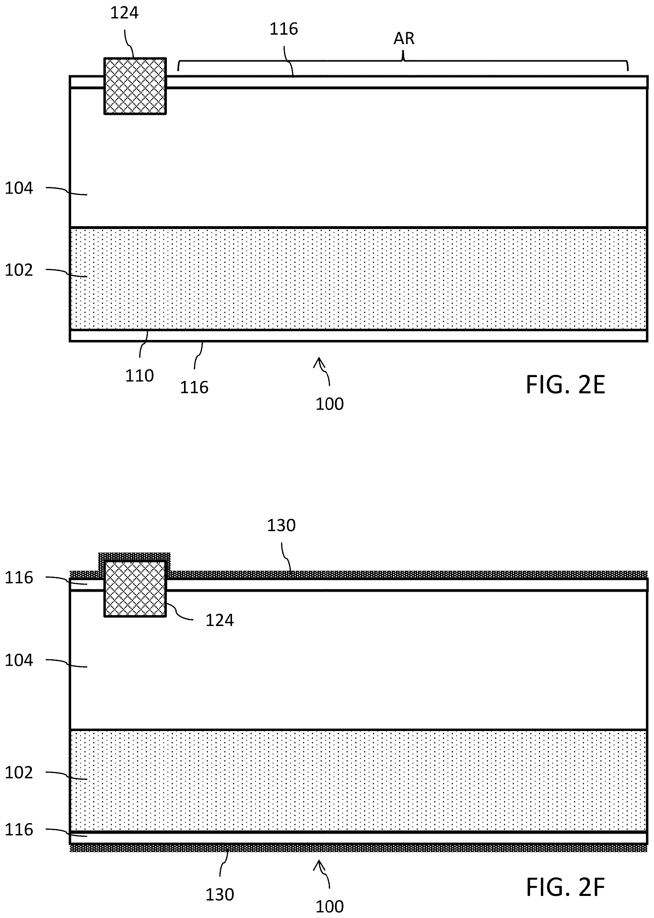

Figure 2E - a local oxidation of silicon (LOCOS) process is then performed to grow a field oxide (FOX) region 124 in and over the epitaxial layer 106 at the opening 122. The field oxide region 124 may have a thickness in a range of, for example, 0.5 to 2 µm. The field oxide region 124 delimits an active region AR of the substrate.

Figure 2F - a layer 130 of tetraethyl orthosilicate (TEOS) is then deposited over the wafer 100 to cover the field oxide region 124 and the thin nitride layer 116 on each of the surfaces 108 and 110. The TEOS layer 130 may have a thickness in a range of, for example, 1000 to 4000 Å.

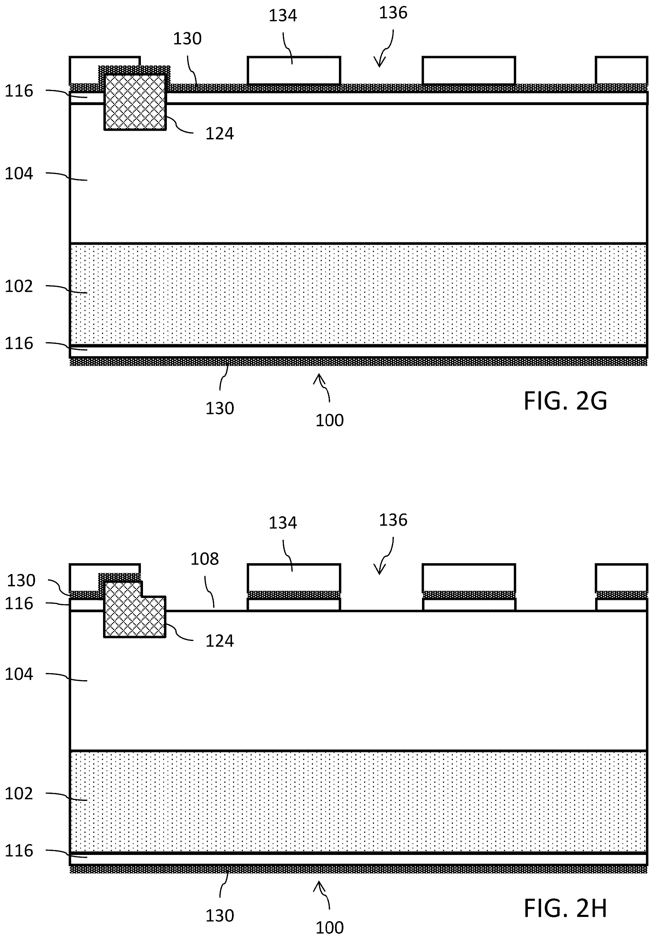

Figure 2G - a resist layer 134 is deposited on the TEOS layer 130 over the surface 108 and lithographically patterned to form mask openings 136 (for trench formation in the active region AR delimited by the field oxide region 124).

Figure 2H - a TEOS and nitride dry etching is then performed through the openings 136 to remove portions of the TEOS layer 130 and underlying nitride layer 116 through the openings 136 and expose the surface 108 at locations where trenches are to be formed.

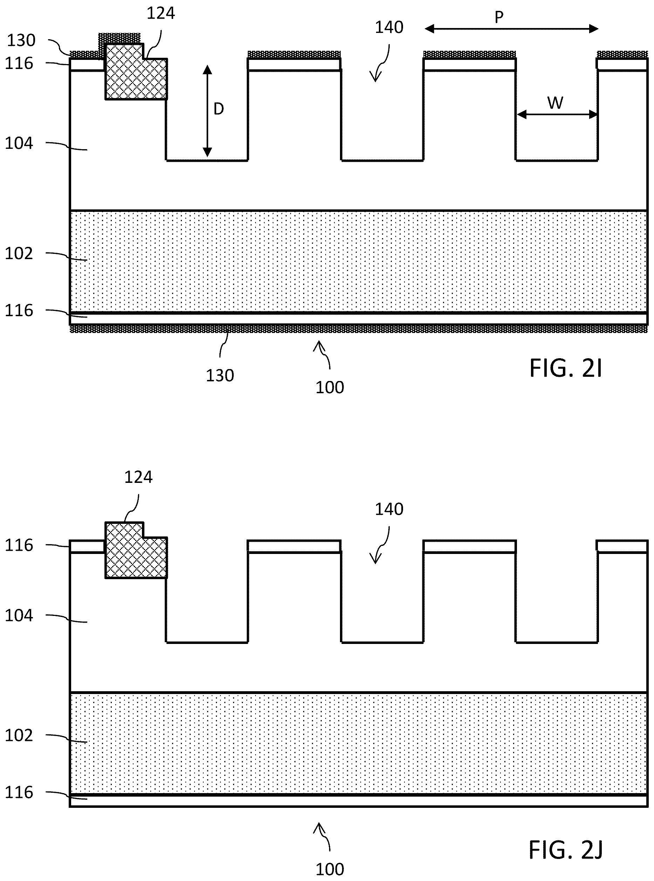

Figure 2I - the patterned resist layer 134 is then stripped (for example, using a dry etch and wet clean). A dry etch is then performed using the remaining portions of the TEOS layer 130 and underlying nitride layer 116 as a mask to open a trench 140 in the substrate epitaxial layer 104 at each of the mask openings 136. The trenches 140 may have a depth D in a range of, for example, 1 to 5 µm and a width W in a range of, for example, 0.5 to 2 µm. Thus, the trench depth extends partially into, without passing completely through, the epitaxial layer 104. The spacing of the trenches 140 may exhibit a pitch P in a range of, for example, 2 to 4 µm, depending on the desired pinching effect.

Figure 2J - the remaining portions of the TEOS layer 130 are then selectively stripped using a suitable wet etching process, and the wafer 100 is again wet cleaned.

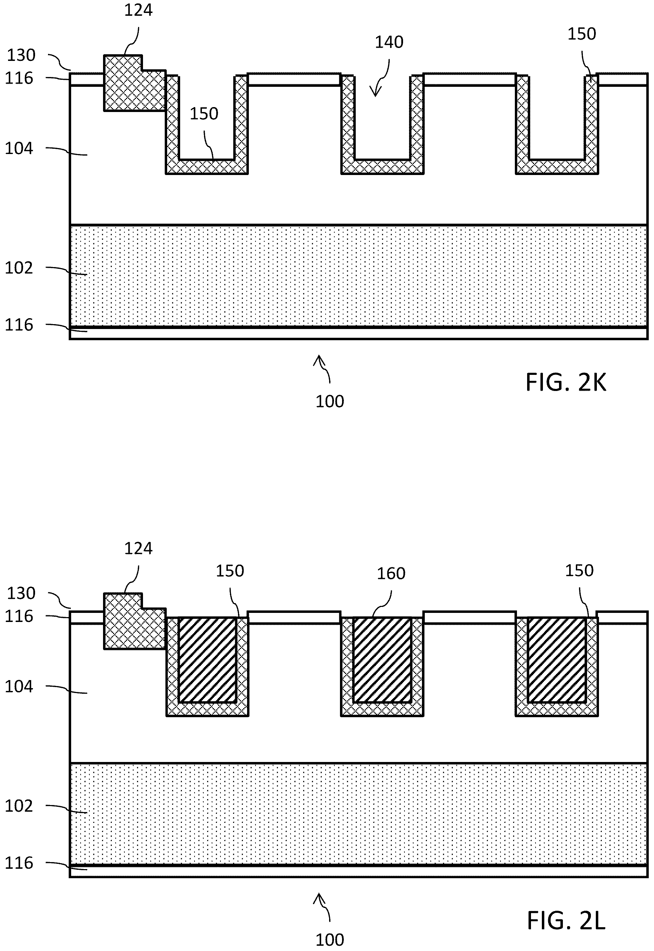

Figure 2K - a trench field plate oxide layer 150 is then formed on the sidewall and bottom surfaces of each trench 140 (for example, using a thermal oxidation of silicon process). This field plate oxide layer 150 has a thickness in a range of, for example, 1000 to 5000 Å.

Figure 2L - a deposition of doped polysilicon material is then made to cover the wafer 100 and fill the trenches 140. The polysilicon material is preferably doped with an N-type dopant. A frontside dry etch is then performed on the wafer 100 to recess the layer of doped polysilicon material to leave polysilicon trench fill 160 only in each trench 140. This polysilicon trench fill 160 is insulated from the first and second epitaxial layers 104 and 106 by the trench insulating layer 150. After the polysilicon layer recess, a standard clean may be performed.

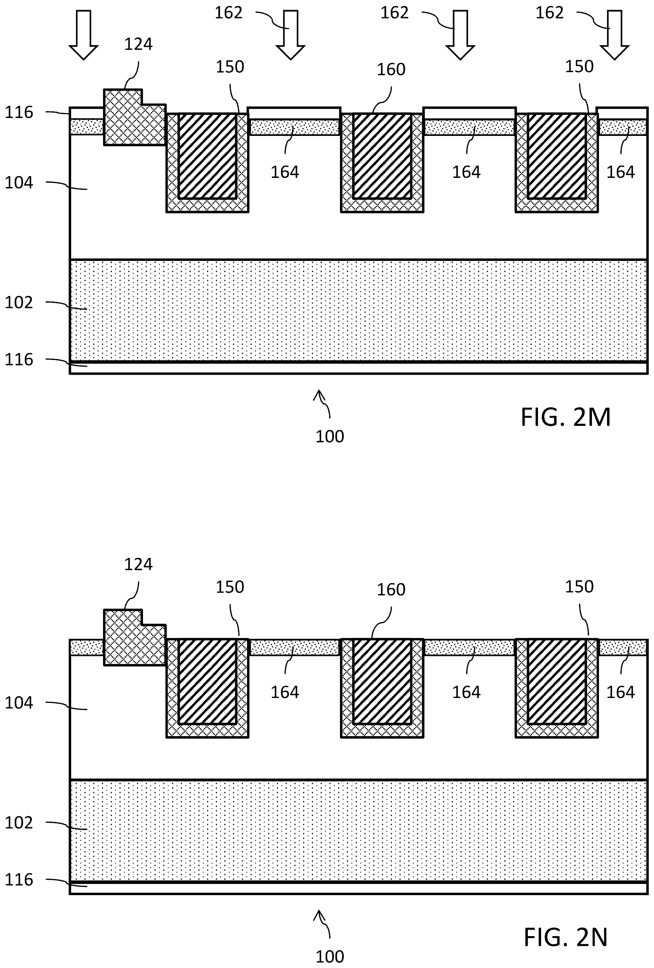

Figure 2M - a dopant implantation 162 is then performed to implant N-type dopant in a doped region 164 of the second epitaxial layer 106 between adjacent trenches 140 lined with the trench insulating layer 150 and filled by the polysilicon trench fill 160. The doped region has an upper surface coplanar with an upper surface of the second epitaxial layer 106 and a depth extending into the second epitaxial layer 106 from its upper surface in a range of, for example, 0.05 to 0.3 µm.

By selection of the particular N-type dopant used for the implantation 162, the dose level for the implantation and the resulting dopant surface concentration level for the region 164, the forward voltage V_{F} of the Schottky diode can be tuned.

As an example, the N-type dopant used for the implantation 162 may, for example, be Phosphorus, implanted with a given dose level and energy, providing a dopant surface concentration for the doped region 164 in a range of, for example, 1.0 x 10¹⁶ to 5.0 x 10¹⁷ at/cm³. The resulting Schottky diode will have a forward voltage V_{F} in a range of about 0.2 to 0.3 Volts (with a reverse leakage current I_{R} that is less than 100 µA).

Figure 3 shows, for a number of samples at reference 200, the forward voltage V_{F} versus reverse leakage current I_{R} characteristics of a Schottky diode including the doped region 164 using an N-type dopant, implanted with a first dose level, providing a first surface dopant concentration level. Figure 3 also shows, for a number of samples at reference 202, the forward voltage V_{F} versus reverse leakage current I_{R} characteristics of a Schottky diode including the doped region 164 using an N-type dopant, implanted with a second dose level higher than the first dose level, providing a second surface dopant concentration level that is higher than the first surface dopant concentration level. For comparison purposes, in the absence of doped region 164 the Schottky diode will have a higher forward voltage V_{F} and a lower reverse leakage current I_{R} as shown for a number of samples at reference 204 of Figure 3. Thus, by controlling the N-type dopant surface concentration level for the doped region 164 through the selection of the dose level and implantation energy in the step of Figure 2M, the forward voltage V_{F} of the produced Schottky diode can be tuned (all other parameters of the device remaining constant).

The surface implantation of region 164 with lightly doped N-type dopants causes band bending near the upper surface of the second epitaxial layer 106 between adjacent trenches 140 at the Schottky barrier and thereby reduces the effective Schottky barrier height resulting in a relative lowering of the forward voltage V_{F}. There is accordingly no need, when tuning the Schottky diode with respect to forward voltage V_{F}, to consider enlarging the die size or changing the process to utilize a different Schottky barrier metal having a lower barrier height.

It will be noted that the implantation process for forming the doped region 164 must be controlled to provide a proper thickness for region 164. The region 164 produced by the implantation must be thick enough so that it is not consumed by the subsequent silicidation process (see below) for forming the Schottky contact and must be thin enough to avoid lowering of the breakdown voltage of the diode. Thus, the right dopant implantation energy level has to be provided so that layer 164 will still be present after silicidation but will not be too thick to avoid breakdown voltage lowering.

Figure 2N - a nitride wet etch (H₃PO₄, for example) is then performed to remove the remaining portions of the nitride layer 116.

It will be noted, as an alternative, removal of the nitride layer 116 may instead be performed prior to the implantation of the doped region 164. In such a case, a blanket implantation (using a lower energy), for example through the use of plasma assisted doping (PLAD), could be used to form the doped region 164.

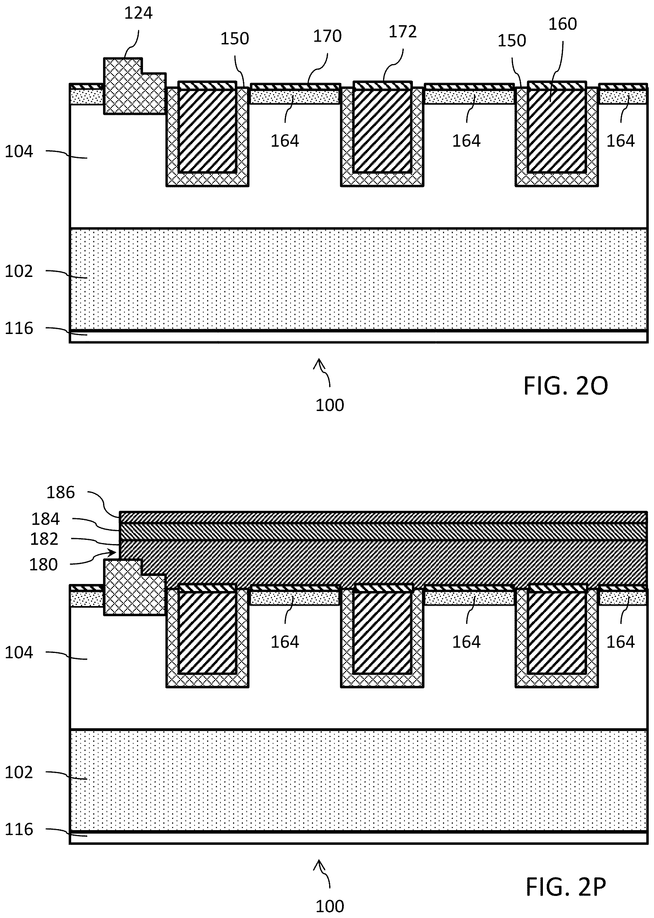

Figure 2O - after performing a wet clean of the wafer 100, a deposition is made of a refractory metal or metal alloy layer on the wafer 100. The refractory metal or metal alloy may, for example, comprise a Platinum-Nickel alloy. A sintering/silicidation (thermal anneal) process is then performed to convert the refractory metal or metal alloy layer to a silicide layer which provides a Schottky barrier 170 on the upper surface each doped region 164 and convert the refractory metal or metal alloy layer to provide a silicide layer 172 on the upper surface of the polysilicon trench fill 160. A selective wet etching is then performed to remove any unreacted portions of the refractory metal or metal alloy layer (such as, for example, portions which are present on the surfaces of the field oxide region 124 and the trench insulating layer 150).

Figure 2P - a stack of metal layers is then formed over the upper surface of the wafer 100. In one embodiment well suited for clip bonding, the stack of metal layers includes a Titanium-Tungsten barrier layer 180, an Aluminum layer 182, a Nickel layer 184, and a Gold layer 186. In another embodiment, not explicitly shown by Figure 2P, well suited for wirebonding, the stack of metal layers includes a Titanium-Tungsten barrier layer, a Nickel layer, and an Aluminum layer. The stack of metal layers, of either configuration mentioned, is lithographically patterned to overlie the area of the wafer 100 where the trenches 140 and doped regions 164 are located.

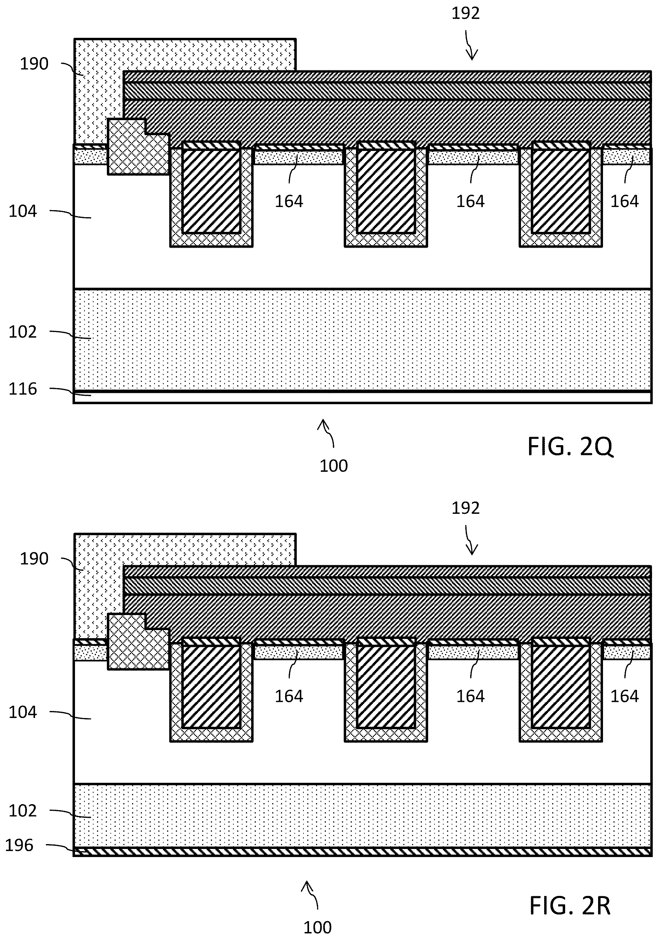

Figure 2Q - a passivation that is provided, for example, by an organic polymeric protective layer 190 is then deposited over the wafer 100 and lithographically patterned to provide a device contact opening 192 where clip bonding or wirebonding at the anode terminal of the diode can be made.

Figure 2R - the backside of the wafer 100 is then processed. Wafer thinning is performed to reduce the thickness of the substrate 102 and a backside metal deposition is performed to deposit a metal layer 196 on the thinned back surface of the substrate 102. The metal layer 196 may comprise, for example, layers of a Titanium, Nickel, Gold providing electrical connection at the cathode terminal of the diode.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method for manufacturing a Schottky diode, comprising:
in an active region of a semiconductor substrate doped with a first conductivity type dopant, forming a plurality of trenches which extend in depth into the semiconductor substrate;
lining sidewall and bottom surfaces of each trenche with an insulating layer;
filling each trench with a polysilicon fill;
implanting a doped region having the first conductivity type dopant in the semiconductor substrate between the trenches;
providing or forming a silicide in contact with the polysilicon fill;
providing or forming a Schottky barrier in contact with the doped region;
providing a first electrical connection for an anode terminal in contact with the silicide and Schottky barrier or connecting an anode terminal to the silicide and Schottky barrier; and
providing a first electrical connection for a cathode terminal in contact with a lower surface of the semiconductor substrate or connecting a cathode terminal to a lower surface of the semiconductor substrate.

2. The method of claim 1, wherein :
the plurality of trenches extend in depth into an epitaxial layer of the semiconductor substrate from an upper surface of the semiconductor substrate;
the doped region having the first conductivity type dopant is implanted in the epitaxial layer of the semiconductor substrate at locations between adjacent trenches; and
the implanting the doped region comprises selecting a dose level for implanting the first conductivity type dopant to form the doped region having a selected dopant concentration level to control setting of a forward voltage V_{F} level for the Schottky diode.

3. A Schottky diode, comprising:
a semiconductor substrate doped with a first conductivity type dopant in an active region of the semiconductor substrate, a plurality of trenches extending in depth into an epitaxial layer of the semiconductor substrate from an upper surface of the semiconductor substrate;
an insulating layer lining sidewall and bottom surfaces of each trench;
a polysilicon fill in each trench;
a doped region having the first conductivity type dopant implanted in the epitaxial layer of the semiconductor substrate at locations between adjacent trenches;
a silicide in contact with each polysilicon fill;
a Schottky barrier in contact with each doped region;
a first electrical connection for an anode terminal in contact with the silicide and Schottky barrier; and
a second electrical connection for a cathode terminal in contact with a lower surface of the semiconductor substrate;
wherein a dopant concentration level of the first conductivity type dopant implanted at the doped region controls setting of a forward voltage V_{F} level for the Schottky diode.

4. The method of claim 2 or the Schottky diode of claim 3, wherein the selected dopant concentration level comprises a relatively higher dopant concentration level for the implanted first conductivity type dopant to set a relatively lower forward voltage V_{F} level.

5. The method of claim 2 or 4, wherein selecting the dose level comprises selecting a relatively higher dose level for implantation of the first conductivity type dopant to set a relatively lower forward voltage V_{F} level.

6. The method of any of claims 2, 4 and 5 or the Schottky diode of claims 3 or 4, wherein the epitaxial layer is provided over a substrate layer, wherein the epitaxial layer is lightly doped with the first conductivity type dopant and the substrate layer is heavily doped with the first conductivity type dopant.

7. The method or the Schottky diode of claim 6, wherein the plurality of trenches extend in depth into the epitaxial layer without reaching the substrate layer.

8. The method of any of claims 2 and 4 to 7 or the Schottky diode of any of claims 3, 4, 6 and 7, wherein an upper surface of the epitaxial layer is coplanar with an upper surface of the doped region.

9. The method of any of claims 2 and 4 to 8 or the Schottky diode of any of claims 3, 4 and 6 to 8, wherein an upper surface of the doped region is coplanar with an upper surface of the semiconductor substrate at locations between adjacent trenches.

10. The method of any of claims 2 and 4 to 9 or the Schottky diode of any of claims 3, 4 and 6 to 9, wherein the dopant concentration level for the implanted first conductivity type dopant at the doped region is higher than a dopant concentration level for the first conductivity type dopant at the epitaxial layer.

11. The method of claim 1, wherein the plurality of trenches is a pair of trenches, the method comprising:
selecting a forward voltage V_{F} level for the Schottky diode;
selecting, based on the selected forward voltage V_{F} level, a dose level for implanting the first conductivity type dopant having a certain dopant concentration level; and
implanting, using the selected a dose level, the doped region having the first conductivity type dopant in the semiconductor substrate between the pair of trenches to set the selected forward voltage V_{F} level for the Schottky diode.

12. The method of claim 11, wherein an upper surface of the doped region is coplanar with an upper surface of the semiconductor substrate.

13. The method of claim 11 or 12, wherein the certain dopant concentration level for the doped region having the first conductivity type dopant is higher than a dopant concentration level for the first conductivity type dopant in the semiconductor substrate.

14. The method of any of claims 11 to 13, wherein a relatively higher dopant concentration level for the certain dopant concentration level corresponds to selecting a relatively lower forward voltage V_{F} level.

15. The method of any of claims 11 to 14, wherein selecting a relatively higher dose level corresponds to selecting a relatively lower forward voltage V_{F} level.
